# EUROPÄISCHE PATENTSCHRIFT

(11) **EP 1 924 960 B1**
(45) Veröffentlichungstag und Bekanntmachung des Hinweises auf die Patenterteilung: **15.08.2012**
(21) Anmeldenummer: 06775912.6
(22) Anmeldetag: 28.08.2006
(51) Int. Cl.: H01L 23/28, H01L 23/00, H01L 23/057, H01L 23/498, G06K 19/077

(54) **CHIPMODUL SOWIE VERFAHREN ZUR HERSTELLUNG EINES CHIPMODULS**
CHIP MODULE AND METHOD FOR PRODUCING A CHIP MODULE
MODULE A PUCE ET PROCEDE DE PRODUCTION ASSOCIE

(30) Priorität: 15.09.2005 DE 102005044216
(43) Veröffentlichungstag der Anmeldung: 28.05.2008
(73) Patentinhaber: Smartrac IP B.V., 1077 XX Amsterdam (NL)
(72) Erfinder: RIETZLER, Manfred, 87616 Marktoberdorf (DE)
(74) Vertreter: Tappe, Hartmut
(86) Internationale Anmeldenummer: PCT/DE2006/001494
(87) Internationale Veröffentlichungsnummer: WO 2007/031050

(56) Entgegenhaltungen:
- EP-A2- 0 122 687
- WO-A-2004/027867
- DE-A1- 19 500 925
- DE-A1- 19 640 304
- US-B1- 6 404 643
- US-B1- 6 613 609

## Beschreibung

Die vorliegende Erfindung betrifft ein Chipmodul zur Herstellung kontaktloser Chipkarten mit einem Chipträger Darüber hinaus betrifft die Erfindung ein Verfahren zur Herstellung eines derartigen Chipmoduls.

Chipmodule, die in den Kartenkörper von Chipkarten implementiert sind, unterliegen aufgrund der im Gebrauch der Karte häufig auftretenden Biegebelastungen der Karte besonderen Beanspruchungen. Dies gilt um so mehr für Chipmodule, die zur Herstellung kontaktloser Chipkarten eingesetzt werden, da derartige Chipmodule nicht über äußere Anschlussflächenanordnungen verfügen, die insgesamt zu einer Versteifung des Chipmoduls beitragen. Um dennoch eine ausreichende Versteifung des Chipmoduls zu erreichen, die den Chip bzw. die Kontaktierung des Chips mit dem Chipträger des Chipmoduls in ausreichender Weise vor mechanischen Biegebeanspruchungen schützt, ist es beispielsweise bekannt, den Chip bzw. das Chipmodul mit einem den Chip einhüllenden Verguss zu versehen. Da dieser Verguss jedoch eine ausreichende Masse aufweisen muss, um einen wirksamen Schutz des Chips darzustellen, ist mit der Aufbringung eines derartigen Vergusses regelmäßig eine nicht unerhebliche Erhöhung der Dicke des Chipmoduls verbunden, die je nach Aufbau des Kartenkörpers der Chipkarte zu Problemen bei der Kartenherstellung führen kann.

Aus der EP 0122687 A2, das als nächstliegender Stand der Technik gesehen wird, ein Chipmodul bekannt, welches auf einem Substrat mit inneren und äußeren Kontakten versehen ist, wobei die inneren Kontakte mit einer Chipeinheit bzw. mit einer Chipoberfläche der Chipeinheit über Bonddrähte kontaktiert sind, die in einem zwischen der Chipoberfläche und einer Abdecklage ausgebildeten Hohlraum angeordnet sind.

Die DE 19640304 A1 zeigt ein Chipmodul zur Herstellung kontaktloser Chipkarten, wobei eine Chipeinheit auf einem Substrat angeordnet ist. Das Chipmodul weist weiter innere und äußere Anschlussflächen auf, welche mit einer Antenne kontaktiert werden können. Eine Abdecklage ist aus einem die Chipeinheit umgebenden Verguss innerhalb eines Versteifungsrahmens gebildet.

Ein ebensolches Chipmodul offenbart die US 6,613,609 B1. Insbesondere eine aus einer Vergussmasse bestehende Abdecklage einer Chipeinheit ist aus einem faserverstärkten Kunstharz gebildet.

Aus der US 6,404,643 B1 ist eine Transponderchipkarte mit einem Chipmodul bekannt, wobei eine Chipeinheit auf einem Substrat angeordnet und von einer Abdecklage umgeben ist. Die Chipeinheit ist mit Anschlussflächen gegen Kontakte einer Antenne kontaktiert, wobei das Chipmodul und die Antenne von einer Lage aus einem adhäsiven Material bedeckt werden.

Der vorliegenden Erfindung liegt die Aufgabe zugrunde, ein Chipmodul bzw. ein Verfahren zur Herstellung eines Chipmoduls vorzuschlagen, das bei wesentlicher Erhöhung der Steifigkeit des Chipmoduls eine nur unwesentliche Erhöhung der Dicke gegenüber einem ungeschützten, also ohne zusätzliche Verstärkungseinrichtung versehenen Chipmodul aufweist.

Diese Aufgabe wird gelöst durch ein Chipmodul mit den Merkmalen des Anspruchs 1 bzw. durch ein Verfahren zur Herstellung eines Chipmoduls mit den Merkmalen des Anspruchs 10.

Das erfindungsgemäße Chipmodul zur Herstellung kontaktloser Chipkarten weist einen Chipträger auf, der auf einem Substrat mit inneren und äußeren Kontakten versehen ist, wobei die inneren Kontakte mit Anschlussflächen einer auf dem Chipträger angeordneten Chipeinheit kontaktiert sind und die äußeren Kontakte zur Kontaktierung mit einer Antenne dienen. Bei dem erfindungsgemäßen Chipmodul ist die Chipeinheit sandwichartig in einem Laminatverbund zwischen dem Substrat und einer faserverstärkten Abdecklage aufgenommen, derart, dass die Abdecklage sowohl mit einer Chipoberfläche als auch benachbart zumindest zweier gegenüberliegender Seitenkanten der Chipeinheit mit dem Substrat verbunden ist.

Bei dem erfindungsgemäßen Chipmodul bildet die Abdecklage eine kraftschlüssige Verbindung zwischen der Chipoberfläche und benachbart zu gegenüberliegenden Seitenkanten der Chipeinheit angeordneten Substratbereichen. Demnach bildet die Abdecklage eine versteifende Brücke zwischen benachbart zu gegenüberliegenden Seitenkanten der Chipeinheit angeordneten Substratbereichen. Die Faserverstärkung der Abdecklage sorgt dabei für die zum Kraftschluss notwendige Übertragung von Zugspannungen.

Die Verbindung zwischen der Abdecklage und den Substratbereichen oder der Abdecklage und der Chipoberfläche kann direkt oder unter zwischenliegender Anordnung weiterer Materialien erfolgen, die je nach Funktion übereinstimmend oder abweichend von den Materialien der Abdecklage oder dem Substrat beschaffen sein können. Beispielsweise kann zwischen der Abdecklage und den Substratbereichen ein versteifender oder schockabsorbierender Umfangsring angeordnet sein. Zwischen der Abdecklage und einer Chipoberfläche und/oder einer Chipoberfläche und dem Substrat können auch beispielsweise UV- oder IR-Strahlung oder Schock absorbierende Flächenlagen angeordnet sein.

Eine sowohl Druckspannungen als auch Zugspannungen aufnehmende Versteifungseinrichtung wird möglich, wenn die Abdecklage auf Epoxidharz-Basis hergestellt ist.

Die Ausbildung des Chipmoduls mit einer die Chipeinheit allseitig umfassenden Gehäusung mit einem zusätzlich zur Abdecklage besonders steif ausgebildeten Chipträger wird möglich, wenn sowohl die Abdecklage als auch das Substrat auf Epoxidharz-Basis hergestellt sind, wobei auch das Substrat mit einer faserverstärkten Lage versehen sein kann.

Eine besonders flache Ausbildung des Chipmoduls im Zusammenwirken mit der durch Einsatz der Abdecklage besonders flach ausgeführten Versteifungseinrichtung wird möglich, wenn die Chipeinheit mit ihren Anschlussflächen gegen die inneren Kontakte des Chipträgers kontaktiert ist, also im sogenannten Flip-Chip-Verfahren mit dem Chipträger verbunden ist.

Eine darüber hinaus noch weitere Verringerung der Dicke des Chipmoduls kann erreicht werden, wenn die Chipeinheit eine gegenüber ihrer standardmäßigen Dicke reduzierte Dicke aufweist.

Gemäß dem erfindungsgemäßen Verfahren zur Herstellung eines Chipmoduls mit einem Chipträger, der auf einem Substrat mit inneren und äußeren Kontakten versehen ist, und einer mit den inneren Kontakten kontaktierten Chipeinheit werden in einem ersten Verfahrensschritt Anschlussflächen der Chipeinheit mit den inneren Kontakten des Chipträgers kontaktiert. Anschließend wird eine faserverstärkte Abdecklage auf die Chipeinheit aufgebracht, derart, dass die Chipeinheit sandwichartig zwischen dem Substrat und der Abdecklage angeordnet ist. Nachfolgend wird die Abdecklage in einem Laminatvorgang einer chipoberfläche und benachbar zumindest zweier gegenüberliegender Seitenkanten der Chipeinheit mit dem Substrat verbunden.

Als besonders vorteilhaft erweist es sich, wenn in dem Laminiervorgang längs der Peripherie der Chipeinheit eine kontinuierliche Verbindung der Abdecklage mit dem Substrat erfolgt, da somit eine die Chipeinheit auf dem Substrat versiegelnde Gehäusung der Chipeinheit geschaffen wird.

Als besonders vorteilhaft erweist es sich, wenn der Laminiervorgang vermittels eines Formwerkzeugs zur Ausbildung einer in ihrer Form definierten Chipgehäusung erfolgt, da somit in besonderer Weise eine Anpassung der Chipgehäusung an die jeweilige Einbau- bzw. Aufnahmesituation des Chipmoduls in den Kartenkörper möglich ist.

Wenn die Kontaktierung der Anschlussflächen der Chipeinheit mit den inneren Kontakten des Chipträgers derart erfolgt, dass die Chipeinheit mit ihren den Kontakten des Chipträgers zugewandten Anschlussflächen gegen die Kontakte des Chipträgers kontaktiert wird, ist ein besonders flacher Aufbau der Chipeinheit möglich.

Die mit der vorstehend erläuterten Flip-Chip-Kontaktierung der Chipeinheit auf dem Substrat erreichbare geringe Dicke des Chipmoduls lässt sich noch weiter reduzieren, wenn nachfolgend der Kontaktierung der Chipeinheit auf dem Chipträger und vorausgehend der Aufbringung der Abdecklage auf die Chipeinheit eine Reduzierung der Dicke der Chipeinheit in einem abrasiven Materialbearbeitungsverfahren erfolgt.

Nachfolgend wird eine bevorzugte Ausführungsform der Erfindung anhand der Zeichnung näher erläutert.

Es zeigen:
- **Fig. 1**: ein Chipmodul in Querschnittsdarstellung und Seitenansicht;
- **Fig. 2**: das in **Fig. 1** dargestellte Chipmodul in einer Seitenansicht gemäß dem Pfeil II in **Fig. 1**;
- **Fig. 3**: das in **Fig. 1** dargestellte Chipmodul in Draufsicht;
- **Fig. 4**: einen Chipträgerverbund aus einer Mehrzahl zusammenhängender Chipträger mit auf den Chipträgern kontaktierten Chipeinheiten in Draufsicht;
- **Fig. 5**: den in **Fig. 4** dargestellten Chipträgerverbund in Seitenansicht mit einer oberhalb der Chipeinheiten angeordneten Abdecklage;
- **Fig. 6**: den in **Fig. 5** dargestellten Chipträgerverbund mit der oberhalb der Chipeinheiten angeordneten Abdecklage während des Laminiervorgangs;
- **Fig. 7**: einen durch den Laminiervorgang geschaffenen Chipmodulverbund vor der Vereinzelung der Chipmodule.

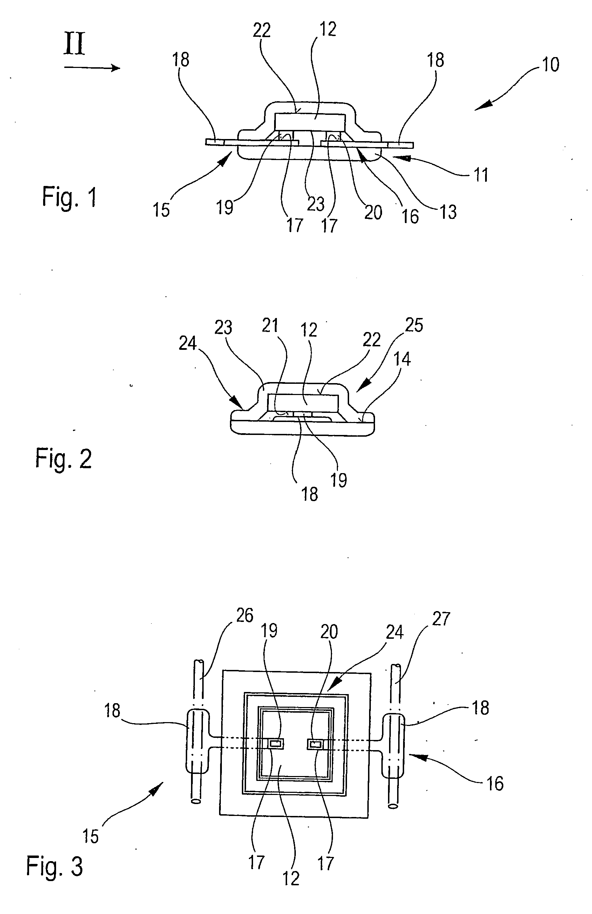

**Fig. 1** zeigt ein Chipmodul 10 mit einer auf einem Chipträger 11 angeordneten Chipeinheit 12. Der Chipträger 11 weist im vorliegenden Fall ein Epoxidharz-Substrat 13 auf, das fachsprachlich auch als sogenanntes "FR4-Substrat" bezeichnet wird. Wie sich ferner aus **Fig. 1** sowie aus einer Zusammenschau mit den **Fig. 2** und **3** ergibt, ist das Substrat 13 auf seiner der Chipeinheit 12 zugewandten Oberseite 14 mit einer Anschlussflächenanordnung, umfassend zwei Anschlussleiter 15 und 16, versehen. Die Anschlussleiter 15, 16 weisen jeweils ein inneres Kontaktende 17 und ein äußeres Kontaktende 18 auf. Die inneren Kontaktenden 17 sind mit Anschlussflächen der Chipeinheit 12 kontaktiert, die im vorliegenden Fall als Kontakthöcker 19, 20 ausgebildet sind.

Auf der einer mit den Kontakthöckern 19, 20 versehenen Vorderseite 21 der Chipeinheit 12 gegenüberliegenden Rückseite 22 der Chipeinheit 12 befindet sich eine Abdecklage 23, die an die Außenkontur der Chipeinheit 12 angeschmiegt und längs einer Peripherie 24 der Chipeinheit 12 mit der Oberseite 14 des Substrats 13 in einem Laminatverbund 35 verbunden ist. Durch ihre die Chipeinheit 12 eingehüllt aufnehmende Ausbildung und den Laminatverbund 35 mit dem Substrat 13 längs der Peripherie 24 der Chipeinheit 12 bildet die Abdecklage 23 eine die Chipeinheit 12 aufnehmende und das Chipmodul 10 insgesamt versteifende Versteifungsvorrichtung.

Wie **Fig. 3** zeigt, ragen seitlich aus einer die Chipeinheit 12 mit dem Substrat 13 versiegelnden Gehäusung 25 lediglich die äußeren Kontaktenden 18 der Anschlussleiter 15, 16 hervor, die zur Kontaktierung mit den in **Fig. 3** lediglich angedeuteten Kontaktenden 26, 27 einer Antenne dienen.

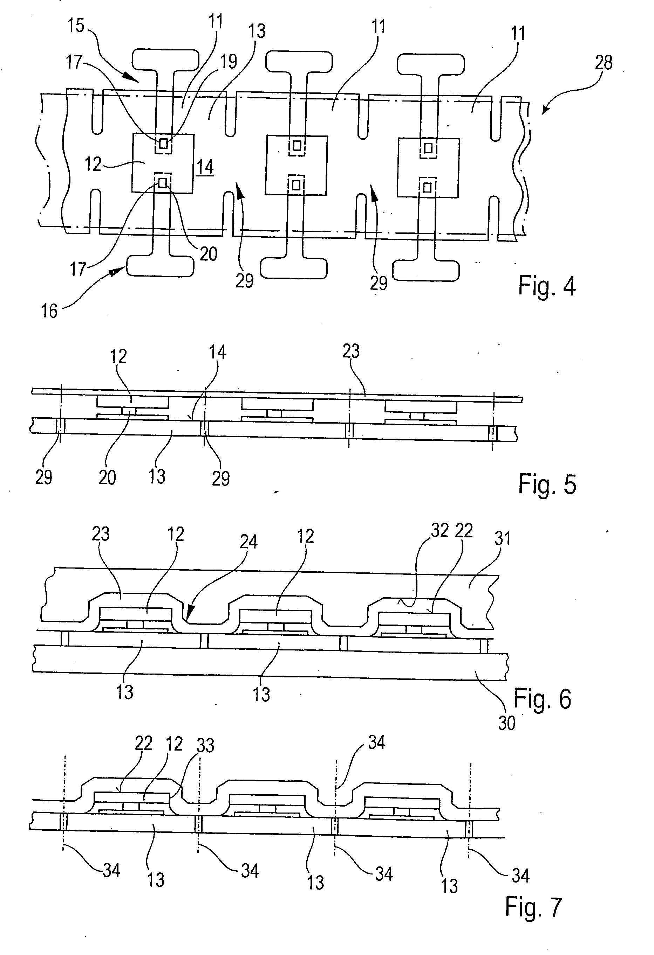

In den **Fig. 4** bis **7** ist nachfolgend ein Herstellungsverfahren zur Herstellung des in den **Fig. 1** bis **3** dargestellten Chipmoduls 10 erläutert.

Wie in **Fig. 4** dargestellt, kann das Verfahren basierend auf einem Chipträgerverbund 28 ausgeführt werden, der eine Vielzahl des in den **Fig. 1** bis **3** dargestellten Chipträgers 11 in zusammenhängender Anordnung aufweist. Zur Vereinzelung einzelner Chipträger 11 weist der Chipträgerverbund 28 durch Verbindungsstege 29 definierte Trennstellen auf. Wie aus einer Zusammenschau der **Fig. 4** und **5** deutlich wird, sind in dem dargestellten Verfahrensstadium bereits Chipeinheiten 12 über ihre Kontakthöcker 19, 20 mit den inneren Kontaktenden 17 der auf der Oberseite 14 des Substrats 13 angeordneten Anschlussleiter 15, 16 kontaktiert. Auf den Rückseiten 22 der Chipeinheiten 12 angeordnet befindet sich die Abdecklage 23, die im vorliegenden Fall aus einem faserverstärkten Epoxidmaterial besteht, das - häufig bezeichnet als Glasfasermatte oder Glasfaserprepreg - ein weitverbreitetes Halbzeug zur Herstellung von Leichtbaukonstruktionen ist.

Dabei bildet bekanntlich das in der Abdecklage 23 vorhandene Epoxidharzmaterial eine laminierfähige, aushärtbare Stützmatrix für die in die Epoxiharzmasse eingebetteten Glasfasern, die eine Übertragung von Zugspannungen ermöglichen. Grundsätzlich können zur Verwendung als Abdecklage 23 auch andere Faserverbundmaterialien verwendet werden, die eine vergleichbare Wirkung zeigen.

Nachfolgend der Anordnung der Abdecklage 23 auf den Rückseiten 22 der Chipeinheiten 12 erfolgt ein Laminiervorgang, bei dem die in **Fig. 5** dargestellte Lagenanordnung, umfassend den Chipträgerverbund 28 und die Abdecklage 23, zwischen einer unteren Laminierplatte 30 und einer oberen Laminierplatte 31 angeordnet wird. Die Laminierplatte 31 ist als Formwerkzeug ausgebildet mit einer in ihrer Anordnung den Chipeinheiten 12 entsprechenden Mehrzahl von Formnestern 32, die so dimensioniert und ausgeformt sind, dass sich bei einem Zusammenführen der Laminierplatten 30, 31, wie in **Fig. 6** dargestellt, ein rückwärtig an die Chipeinheiten 12 angeschmiegter Verlauf der Abdecklage 23 mit einem gleichzeitigen Andrücken der Abdecklage 23 an die Substrate 13 des Chipträgerverbunds 28 in den Peripheriebereichen 24 der Chipeinheiten 12 einstellt. In der in **Fig. 6** dargestellten Konfiguration wird zumindest die Laminierplatte 31 mit Temperatur beaufschlagt, so dass sich der in **Fig. 7** dargestellte formhaltige Laminatverbund 35 zwischen der Abdecklage 23 und den Substraten 13 des Chipträgerverbunds 28 in den Peripheriebereichen 24 der Chipeinheiten 12 einstellt. Die Verbindung der Abdecklage 23 mit den Chipeinheiten 12 erfolgt dabei über eine formschlüssige Aufnahme der Chipeinheiten 12 im Bereich von deren Rückseiten 22 und Außenseiten 33.

Ausgehend von der in **Fig. 7** dargestellten Konfiguration muss nun zur Herstellung der in den **Fig. 1** bis **3** dargestellten Chipmodule 10 lediglich noch eine Vereinzelung durch einen Stanz- oder Schneidvorgang zum Durchtrennen der Verbindungsstege 29 an den in **Fig. 7** gekennzeichneten Trennstellen 34 erfolgen.

## Patentansprüche

1. Chipmodul (10) zur Herstellung kontaktloser Chipkarten, wobei das Chipmodul (10) einem Chiptüngen (11) und ein substrat (13) aufweist, wobei das Substrat (13) mit inneren (17) und äußeren (18) Kontakten versehen ist, wobei die inneren Kontakte (17) mit Anschlussflächen einer auf dem Chipträger angeordneten Chipeinheit kontaktiert sind und die äußeren Kontakte (18) zur Kontaktierung mit einer Antenne dienen,
**dadurch gekennzeichnet,**
**dass** die Chipeinheit (12) sandwichartig in einem Laminatverbund zwischen dem Substrat (13) und einer faserverstärkten Abdecklage (23) aufgenommen ist, wobei die Abdecklage benachbart zumindest zweier gegenüberliegender Seitenkanten der Chipeinheit (12) mit dem Substrat (13) verbunden ist, derart, dass die als Laminatlage ausgebildete Abdecklage eine kraftschlüssige Verbindung zwischen der Chipoberfläche und benachbart zu gegenüberliegenden Seitenkanten der Chipeinheit angeordneten Substratbereichen ausbildet.

2. Chipmodul nach Anspruch 1,
**dadurch gekennzeichnet,**
**dass** die Verbindung der Abdecklage mit dem Substrat unter Anordnung mindestens eines zwischenliegenden Materials zwischen der Abdecklage und dem Substrat erfolgt.

3. Chipmodul nach Anspruch 2,
**dadurch gekennzeichnet,**
**dass** das zwischenliegende Material als Umfangsring ausgebildet ist.

4. Chipmodul nach Anspruch 1,
**dadurch gekennzeichnet,**
**dass** die Abdecklage (23) längs einer peripherie (24) der Chipeinheit (12) mit dem Substrat (13) verbunden ist.

5. Chipmodul nach einem der vorangegangenen Ansprüche,
**dadurch gekennzeichnet,**
**dass** die Verbindung der Abdecklage mit der Chipoberfläche unter Anordnung mindestens eines zwischenliegenden Materials zwischen der Abdecklage und der Chipoberfläche erfolgt.

6. Chipmodul nach einem der vorangehenden Ansprüche,
**dadurch gekennzeichnet,**
**dass** die Abdecklage (23) auf Epoxidharz-Basis hergestellt ist.

7. Chipmodul nach Anspruch 6,
**dadurch gekennzeichnet,**
**dass** die Abdecklage (23) und das Substrat (13) auf Epoxidharz-Basis hergestellt sind.

8. Chipmodul nach einem der vorangehenden Ansprüche,
**dadurch gekennzeichnet,**
**dass** die Chipeinheit (12) mit ihren Anschlussflächen (19, 20) gegen die inneren Kontakte (17) des Chipträgers (11) kontaktiert ist.

9. Chipmodul nach Anspruch 8,
**dadurch gekennzeichnet,**
**dass** die Chipeinheit (12) eine reduzierte Dicke aufweist.

10. Verfahren zur Herstellung eines Chipmoduls (10) mit einem Chipträger (11), der auf einem Substrat (13), das mit inneren (17) und äußeren (18) Kontakten versehen ist, aufgebracht ist, und einer mit den inneren Kontakten (17) kontaktierten Chipeinheit (12), **dadurch gekennzeichnet,**
**dass** in einem ersten Verfahrensschritt Anschlussflächen (19, 20) der Chipeinheit (12) mit den inneren Kontakten (17) des Chipträgers (11) kontaktiert werden,
anschließend eine faserverstärkte Abdecklage (23) auf die Chipeinheit (12) aufgebracht wird, derart, dass die Chipeinheit (12) sandwichartig zwischen dem Substrat (13) und der Abdecklage (23) angeordnet ist,
und nachfolgend in einem Laminiervorgang die Abdecklage (23) mit einer Chipoberfläche (22, 23) der Chipeinheit und benachbart zumindest zweier gegenüberliegender Seitenkanten der Chipeinheit (12) mit dem Substrat (13) verbunden wird, derart, dass die als Laminatlage ausgebildete Abdecklage eine kraftschlüssige Verbindung zwischen der Chipoberfläche und benachbart zu gegenüberliegenden Seitenkanten der Chipeinheit angeordneten Substratbereichen ausbildet.

11. Verfahren nach Anspruch 10,
**dadurch gekennzeichnet,**
**dass** in dem Laminiervorgang längs der Peripherie (24) der Chipeinheit (12) eine kontinuierliche Verbindung der Abdecklage (23) mit dem Substrat (13) erfolgt.

12. Verfahren nach Anspruch 10 oder 11,
**dadurch gekennzeichnet,**
**dass** der Laminiervorgang vermittels eines Formwerkzeugs (31) zur Ausbildung einer in ihrer Form definierten Chipgehäusung (25) erfolgt.

13. Verfahren nach einem der Ansprüche 10 bis 12,
**dadurch gekennzeichnet,**
**dass** die Kontaktierung der Anschlussflächen (19, 20) der Chipeinheit (12) mit den inneren Kontakten (17) des Chipträgers (11) derart erfolgt, dass die Chipeinheit (12) mit ihren den Kontakten des Chipträgers (11) zugewandten Anschlussflächen (19, 20) gegen die Kontakte des Chipträgers (11) kontaktiert wird.

14. Verfahren nach Anspruch 13,
**dadurch gekennzeichnet,**
**dass** nachfolgend der Kontaktierung der Chipeinheit (12) auf dem Chipträger (11) und vorausgehend der Aufbringung der Abdecklage (23) auf die Chipeinheit (12) eine Reduzierung der Dicke der Chipeinheit (12) in einem abrasiven Materialbearbeitungsverfahren erfolgt.

## Claims

1. A chip module (10) for producing contactless chip cards, the chip module (10) comprising a chip carrier (11) and a substrate (13), the substrate (13) being provided with inner (17) and outer (18) contacts, wherein the inner contacts (17) are bonded to terminal areas of a chip unit arranged on the chip carrier and the outer contacts (18) serve for being bonded to an antenna
**characterized in that**
the chip unit (12) is accommodated in a sandwich-like fashion in a laminated connection between the substrate (13) and a fibre-reinforced cover layer (23), the cover layer being connected to the substrate (13) adjacent to at least two opposite lateral edges of the chip unit (12), in such a way that the cover layer being formed as a laminate layer forms a force-fit connection between the chip surface and substrate areas being arranged adjacent to opposite lateral edges of the chip unit.

2. The chip module according to claim 1,
**characterized in that**
the connection of the cover layer with the substrate is carried out by arrangement of at least one intermediate material between the cover layer and the substrate.

3. The chip module according to claim 2,
**characterized in that**
the intermediate material is formed as a peripheral ring.

4. The chip module according to claim 1,
**characterized in that**
the cover layer (23) is connected to the substrate (13) along a periphery (24) of the chip unit (12).

5. The chip module according to one of the preceding claims,
**characterized in that**
the connection of the cover layer with the chip surface is carried out by arrangement of at least one intermediate material between the cover layer and the substrate.

6. The chip module according to one of the preceding claims,
**characterized in that**
the cover layer (23) is produced on the basis of epoxy resin.

7. The chip module according to claim 6,
**characterized in that**
the cover layer (23) and the substrate (13) are produced on the basis of epoxy resin.

8. The chip module according to one of the preceding claims,
**characterized in that**
the chip unit (12) with its terminal areas (19, 20) is bonded against the inner contacts (17) of the chip carrier (11).

9. The chip module according to claim 8,
**characterized in that**
the chip unit (12) has a reduced thickness.

10. A method for producing a chip module (10) comprising a chip carrier (11) that is arranged on a substrate (13) being provided with inner (17) and outer (18) contacts, and comprising a chip unit (12) bonded to the inner contacts (17),
**characterized in that**
terminal areas (19, 20) of the chip unit (12) are bonded to the inner contacts (17) of the chip carrier (11) in a first process step, a fibre-reinforced cover layer (23) is subsequently applied onto the chip unit (12) in such a way that the chip unit (12) is arranged in a sandwich-like fashion between the substrate (13) and the cover layer (23),
and subsequently in a laminating process the cover layer (23) is connected to a chip surface (22, 33) of the chip unit and is connected to the substrate (13) adjacent to at least two opposite lateral edges of the chip unit (12), in such a way that the cover layer being formed as a laminate layer forms a force-fit connection between the chip surface and substrate areas being arranged adjacent to opposite lateral edges of the chip unit.

11. The method according to claim 10,
**characterized in that**
a continuous connection between the cover layer (23) and the substrate (13) is produced along the periphery (24) of the chip unit (12) during the laminating process.

12. The method according to claim 10 or 11,
**characterized in that**
the laminating process is carried out by means of a die (31) for forming a chip encapsulation (25) with a defined shape.

13. The method according to one of claims 10 to 12,
**characterized in that**
the bonding of the terminal areas (19, 20) of the chip unit (12) to the inner contacts (17) of the chip carrier (11) is carried out in such a way that the chip unit (12) is bonded against the contacts of the chip carrier (11) with its terminal areas (19, 20) facing the contacts of the chip carrier (11).

14. The method according to claim 13,
**characterized in that**
the thickness of the chip unit (12) is reduced by means of an abrasive material processing method subsequent to the bonding of the chip unit (12) on the chip carrier (11) and prior to the application of the cover layer (23) onto the chip unit (12).

## Revendications

1. Module à puce (10) pour la fabrication de cartes à puce sans contact, le module à puce (10) comprenant un support de puce (11) et un substrat (13), le substrat (13) étant muni de contacts intérieurs (17) et de contacts extérieurs (18), les contacts intérieurs (17) étant mis en contact avec des zones terminales d'une unité de puce étant disposée sur le support de puce et les contacts extérieurs (18) servant à être mis en contact avec une antenne,
**caractérisé en ce que**
l'unité de puce (12) est logée à la manière d'un sandwich dans une structure laminée entre le substrat (13) et une couche de recouvrement (23) renforcée en fibres, la couche de recouvrement étant reliée avec le substrat (13) à côté d'au moins deux bords latéraux opposés de l'unité de puce (12) de telle manière que la couche de recouvrement étant conçue en tant que couche laminée produise une connexion par adhérence entre la surface de puce et des zones de substrat étant disposées à côté de bords latéraux opposés de l'unité de puce.

2. Module à puce selon la revendication 1,
**caractérisé en ce que**
la connexion de la couche de recouvrement avec le substrat est réalisée en plaçant au moins un matériau intermédiaire entre la couche de recouvrement et le substrat.

3. Module à puce selon la revendication 2,
**caractérisé en ce que**
le matériau intermédiaire est conçu en tant qu'anneau périphérique.

4. Module à puce selon la revendication 1,
**caractérisé en ce que**
la couche de recouvrement (23) est reliée avec le substrat (13) le long d'une périphérie (24) de l'unité de puce (12).

5. Module à puce selon l'une quelconque des revendications précédentes,
**caractérisé en ce que**
la connexion de la couche de recouvrement avec la surface de puce est réalisée en plaçant au moins un matériau intermédiaire entre la couche de recouvrement et la surface de puce.

6. Module à puce selon l'une quelconque des revendications précédentes,
**caractérisé en ce que**
la couche de recouvrement (23) est fabriquée sur la base de résine époxy.

7. Module à puce selon la revendication 6,
**caractérisé en ce que**
la couche de recouvrement (23) et le substrat (13) sont fabriqués sur la base de résine époxy.

8. Module à puce selon l'une quelconque des revendications précédentes,
**caractérisé en ce que**
l'unité de puce (12) avec ses zones terminales (19, 20) est mise en contact contre les contacts intérieurs (17) du support de puce (11).

9. Module à puce selon la revendication 8,
**caractérisé en ce que**
l'unité de puce présente une épaisseur réduite.

10. Procédé pour la fabrication d'un module à puce (10) comprenant un support de puce (11) étant disposé sur un substrat (13) étant muni de contacts intérieurs (17) et de contacts extérieurs (18), et comprenant une unité de puce (12) étant mise en contact avec les contacts intérieurs (17),
**caractérisé en ce que**
les zones terminales (19, 20) de l'unité de puce (12) sont mises en contact avec les contacts intérieurs (17) du support de puce (11) dans une première étape de processus, une couche de recouvrement (23) renforcée en fibres est ensuite appliquée sur l'unité de puce (12) telle que l'unité de puce est disposée à la manière d'un sandwich entre le substrat (13) et la couche de recouvrement (23),
et dans un procédé de laminage la couche de recouvrement (23) est ensuite reliée avec une surface de puce (22, 33) de l'unité de puce et est reliée avec le substrat (13) à côté d'au moins deux bords latéraux opposés de l'unité de puce (12) telle que la couche de recouvrement étant conçue en tant que couche laminée réalise une connexion par adhérence entre la surface de puce et des zones de substrat étant disposées à côté de bords latéraux opposés de l'unité de puce.

11. Procédé selon la revendication 10,
**caractérisé en ce qu'**
une connexion continue est produite entre la couche de recouvrement (23) et le substrat (13) le long de la périphérie (24) de l'unité de puce (12) au cours du processus de laminage.

12. Procédé selon la revendication 10 ou 11,
**caractérisé en ce que**
le processus de laminage est réalisé au moyen d'un moule (31) pour former une encapsulation de puce (25) ayant une forme définie.

13. Procédé selon l'une quelconque des revendications 10 à 12, **caractérisé en ce que**
la mise en contact des zones terminales (19, 20) de l'unité de puce (12) avec les contacts intérieurs (17) du support de puce (11) est réalisée telle que l'unité de puce (12) est mise en contact contre les contacts du support de puce (11) avec ses zones terminales (19, 20) faisant face aux contacts du support de puce (11).

14. Procédé selon la revendication 13,
**caractérisé en ce que**
l'épaisseur de l'unité de puce (12) est réduite au moyen d'un processus de traitement de matériau abrasif suivant la mise en contact de l'unité de puce (12) sur le support de puce (11) et précédant l'application de la couche de recouvrement (23) sur l'unité de puce (12).
